# EUROPEAN PATENT APPLICATION

(11) **EP 1 953 763 A1**
(43) Date of publication of application: **06.08.2008**
(21) Application number: 06804610.1
(22) Date of filing: 02.11.2006
(51) Int. Cl.: G12B 21/20

(54) **SCANNING NANOJET MICROSCOPE AND THE OPERATION METHOD THEREOF**

(30) Priority: 02.11.2005 BY 20051058
(71) Applicant: Ilyanok, Alexander Mikhailovich, Minsk, 220007 (BY)
(72) Inventor: TIMOSHCHENKO, Igor Andreevich, Minsk, 220007 (BY)
(74) Representative: Sloboshanin, Sergej
(86) International application number: PCT/BY2006/000008
(87) International publication number: WO 2007/051275

(57) **Abstract**

The inventive scanning nanojet microscope comprises one or several nozzles for producing an agent scanning jet and a system for collecting a radiation obtained in the area where the jet contacts an object. The nozzle is embodied in the form of an optical resonator made from a light-transparent capillary into which walls a narrow band light radiation is introduced by means of a light guide. The capillary length is selected is such a way that it is multiple of the light radiation half-wavelength. The inventive method consists in producing a heterogeneous light pressure on the jet and in carrying out the object three-dimensional scanning, wherein the interruption of the light radiation interrupts the jet and the microscope resolving power is defined by the jet diameter. Said microscope can be used in a scanning jet lithography for controlling a production process in a real-time mode. The microscope makes it possible to non-destructively study dielectrical and biological objects devoid of a current-conducting coating and to monitor a living cell in a real-time

## Description

### Field of the invention.

The invention - a scanning nanojet microscope relates to the field of the measuring equipment for observing an enlarged image of an object with a nanometer resolution and centimeter fields of view in real time. The scanning is realized by a continuous or dropped nanojet controlled by lasers or light diodes. The image is formed at a contact point between the jet and the object as a result of a mechanical impact and a generation of a radiation due to physical and chemical processes. Thereby, the observed object can have a different physical nature including a live cell and be observed indestructibly.

### Background of the invention.

A microscopy is known to be a set of methods of observing and investigation with the help of different physical phenomena. For microscopes there are two main ways to observe an object - a parallel and a subsequent ones. Usually in the parallel methods one uses photons, phonons, electrons, ions and corresponding them elements of a wave optic. The subsequent method is based on scanning (bitmapped) methods of generation of an enlarged image. To these methods are related scanning electron and ion microscopes, scanning acoustical microscopes and near field optical microscopes, confocal optical microscopes, scanning tunnel electron and ion microscopes, scanning atomic and magnetic force microscopes. A separate class of microscopes used the subsequent method is formed by electron and ion projectors in which a field electron or an ion emission from sharp needles is applied and high strength electrostatic fields and a fluorescent screen functions as an image enlarging [1].

The main disadvantage of microscopes existing at the present time, which microscopes allow obtaining a nanometer resolution necessary for nanoelectronics and for an investigation of biological objects at the molecular level is the following.

To obtain the nanometer resolution it is impossible to use the visible range of the optical radiation with classical optics due to a diffraction limit. Thus, in the optical range one uses microscopes scanning by a capillary λ/10-λ/20 in the diameter. These microscopes have a small aperture due to using of a near-field electromagnetic radiation. That takes away the diffraction limit. However, this method can be used for scanning at the distance λ/10-λ/20 from the capillary only. That fact complicates the mechanical ways of scanning of the observed object essentially. Therefore, one uses microscopy methods at shorter electromagnetic wavelengths or microscopy methods using electrons or ions.

At present time the industry has achieved a 65 nm resolution in the production of integrated circuits by the parallel method with the use a soft ultraviolet radiation (photolithography) for which there are transparent materials in the nature. The further increase of a packing density of the integrated circuits requires an increase of a photolithography resolution to 6,5-35 nm, i.e. a nanolithography. Today the increase of the resolution is achieved by the use X-rays and an extreme ultra violet (EUV) radiations that requires reflective optics only. That complicates the technological control essentially. At the present time the following methods of the parallel control of a lithography process and a photo masks producing are used: an electron and an ion microscopy, an X-ray and a EUV microscopy.

Due to the high energy of photons having more than 100 eV the X-ray microscopy decreases the resolution because of a deep penetration of photons in a material and an appearance of a high-energy secondary electrons. Moreover, a generation of bright sources of a soft X-rays radiation requires using of electron synchrotrons that is very expensive.

One assumes that for the serial production of the IC's with a resolution equals 6,5 - 35 nm the EUV lithography (EUVL) is suitable only. The using of this method allows transferring a circuit figure on a substrate as the whole, i.e. that is the parallel method having a high field of view up to 10 cm² [2]. It is suitable to carry out the monitoring of EUVL in the same wavelength range. However, EUVL has a very high factor of energy losses due to a low efficiency of transformation of the electrical energy in the extreme ultraviolet since a laser plasma is used. Moreover, there is a high factor of losses in the reflection optic consisting of a Bragg multilayer coating on the atomic smooth surface of the massive substrate.

Except the parallel lithography method there are also sequential methods. Let's consider the history of generation of sequential microscopy methods with reference to the sequential nanolithography methods.

The main unit of sequential nanotechnological apparatuses is a nanoreactor in which local physicochemical processes in the nanometer range take place under the influence of a probe energy. The probe itself scans a surface subsequently (line-by-line). The scanning is carried out either by a magnetic field in the case of utilizing of nanometer electronic or ion beams or mechanically as scanning microscopes STM, AFM, or as a scanning optical near field microscope (SNOM).

The application of the electronic or ion beams for scanning allows obtaining a large field of view up to square centimeters. Theoretically, the resolution of such a beam is determined by a de Broigle wavelength of a particle. E.g., for the 150 eV electron one has to obtain the 0,1 nm resolution. However, in the practice the scanning electron microscopy resolution merely 5-10 nm has been achieved by the electron beam energy 100 keV. It is related to the fact that the electronic and the ion beams are the "gaseous" jets with high Coulomb repulsive forces that does not allow achieving the high density of the beam. The difficulty of focusing of such beams leads to an impossibility to generate a high current in the beam (the low brightness), and therefore, the low efficiency takes place. Moreover, due to a charge accumulation an electro-conductive substrate is required to work with these beams. Thus, because of the low efficiency (more than one hour) the scanning with help of the electronic and ion beams in the nanolithography can be used for manufacturing of master templates only. Moreover, the high energy of the focused electrons leads to a considerable destruction of used materials that limits the spatial resolution of the method. An advantage is considered in a possibility of a direct observation and monitoring of the manufacturing process of the template in the different power ranges with help of the secondary electrons or the photons.

The usage of the scanning tunnel microscopy methods for nanolithography allows obtaining the bright enough (high-current) electron sources for curing out local chemical reactions and obtaining the high resolution less than 0,1 nm and in the same time obtaining the picture with the same resolution. However, other problems arise here. In essence, the chemical reactions are performed sequentially with separate atoms or molecules and the time of each reaction amounts to 10⁻⁸ -10⁻⁹ seconds. Due to that the generation of one pixel of the figure with the size 14.5×14.5 nm takes 2·10⁻⁴ seconds. Then, the scanning process of merely 1 cm² with a number of the pixels 4,7·10¹¹ takes some months of the continuous work. Due to the usage of the mechanical scanning systems on the piezoceramic the view area is measured only in 10-100 µm². Moreover, because of a mechanical hysteresis of the piezoceramic it is impossible to return a probe needle of the microscope to the start point that causes an adjustment problem. The similar problems have AFM and SNOM. Moreover, the control in these systems is carried out after the manufacturing of the topological figure that complicates and elongates all process considerably. In other words the use a thin brush (probe) to draw wide bands is unproductive. E.g., it is necessary to find a method to create a sufficiently wide probe that can operate with nanometer accuracy on large areas.

As it follows from said above, there is a number of problems for the nanolithography sequential methods and as the result for the microscopy, which problems has to be solved to make possible the operative monitoring of the technological process.

No less important is an application of the microscopy to observe nanoscaled biological objects. In first, they are all cell membranes, viruses, cell organelles, etc. And it is desirable to study the dynamics of live objects in real time without their damaging. The hard radiation such as ultraviolet, X-ray, electron and ion beams destroys biological objects. Therefore, for they observation one uses special methods of fixation by freezing of objects or by coating them with thin metal layers. That changes the chemical and biological essence of the object and does not allow studying its dynamic. For example, the research of a virus penetration process through a cell membrane requires a subsequent fixation (killing) and photographing the process at each step, whereby for each step a new cell and a new virus is required. This is an exceptionally laborious and unproductive procedure.

At the present time the luminescent (fluorescent) optical microscopy is used to study the live cell. In these methods the photoluminescence is used that is peculiar to the nature either of the microobject (cell) itself or of an object with special dyes - fluorochromes. As the result one can observe a color contrasting luminescence image that allows discovering morphological and chemical peculiarities of the object.

The far field fluorescent microscopy with a resolution unlimited by the diffraction allows to obtain the transverse (x and y) resolution 40-80 nm by the use of a 793 nm laser, i.e., in 16 times lower than the excitation wavelength [3, 4]. This microscopy method is based on a simple idea, namely, a localization of the light source. Then, the object is essentially getting a light source by itself. Therefore, one can distinguish two light sources (fluorescence centers) at the distances being much less than wavelength of the source. An advantage of this and another optical methods is a possibility of a nondestructive observation of the live objects. Also, these methods allow obtaining a stereoscopic image due to observation by two optical systems with an angle about 15° between them. A disadvantage of the method is a low concentration of the luminescence centers that results in the low image brightness and as a consequence in the long exposure time.

As prototypes in this invention a conjugation of wide known principles of operation of following devices is used: a jet printer, that forms a figure with the help of ink drops by scanning the page [13], a scanning electron microscope, that scans by a narrow electron beam along large areas [1], a device for an electrical control of a spatial structure of narrow-band light beams [5]. But these devices and operation methods thereof do not allow to obtain a nanometer resolution on the large areas without the destructing of the objects.

The object of the invention is to increase a resolution of the scanning microscope up to the nanometer range during the observation of technological operations in real time without destruction of the monitored object. Thereby, during the execution of nanolithography operations the scan area should be up to several cm².

One possible solution of the object of the invention is using of liquid jets of few nanometers in diameter for generation an image by a method of scanning of the object with this jet from the large distance [5]. However, theoretical calculations of a nanojet motion show in [6, 7] that the jets at the exit from a capillary widen and break along the distance, that makes their use being difficult at long distances from a substrate. Moreover, it is difficult to form nanojet consisting of a chemically active substance preventing its chemical reaction with walls of a nozzle, since the covering these walls with aurum does not give proper efficiency [7].

To form the liquid nanojet non-breaking at 10 cm distance and being able to scan the area of 1-10 cm², one should take into consideration all factors that affect to the nanojet at its motion in the capillary and by its exit to the vacuum.

That is known that under the atmosphere pressure nano-scale bubbles appear in liquid which have the diameter 3-10 nm and the concentration 10¹² per cm³ [8]. The motion of the bubbles in the jet can cause non-stationary effects, namely a jet decay and capitation processes on the substrate surface at a jet hitting point. That can lead to uncontrolled processes and defects during a research of the object.

The capillary pressure in a bubble is defined by the relationship *P* = σ/2π*r_{b}*, where σ is a surface tension coefficient and *r*_{b} is a bubble radius. For example, for the water under the normal conditions this pressure equals *P*= 1,57 MPa. By increasing of the external pressure up to about 1.6 MPa the bubbles disappear. Therefore, to the form homogeneous jet it is necessary to generate in this jet the pressure at least 1,6 Mpa [9].

A condition of the stability of the jet at the capillary exit can be derived from a ratio of a surface tension coefficient σ to a dynamical viscosity η. The critical speed for dielectric liquids when they flow still laminar does not exceed υ*_{cr}* = σ/η. This value for the water equals 72 m/s. Experiments show that it is possible to form the long stable jet by only taking into consideration this critical speed [10]. In [6] the jet speed under consideration was 400 m/s that is greater by a factor of ten than the critical speed. That was the main reason why the obtaining of the stable jet was impossible for them.

Taking into account all factors described above which affect on the nanojet while it moves in the capillary and at the exit to the vacuum we propose the following method of the nanojet creation [5].

The liquid under the pressure required for a collapse of the bubstones is injected into a convergent hollow fiber made from the melted quartz glass, whereas a laser beam is introduced into walls of this fiber. The convergent capillary allows the light energy to be concentrated in a liquid activation zone namely in a capillary nozzle. The laser exerts the radiation pressure on the substance and prevents its contact with the walls. In [11] the ways of formation of the laser beams with the specified spatial structure are shown. The fiber is covered with a metal film in order to confine the light in the fiber. The pressure generated by photons will be determinate by an absorption cross section of atoms. The maximal light pressure is generated by resonance absorption. The resonance pressure force on an atom *F* is estimated as an impulse transferred by photons flux with density *N* in the time unit: *F = Nℏk*ϑ*,* where *ℏk =* 2πℏ/λ is an impulse of one photon, ϑ ≈ λ² is a resonance photon absorption cross section, λ is light wavelength. At saturation the radiation pressure force ceases to depend on the intensity and is determined by the spontaneous decay rate. For typical values of the spontaneous decay rate about 10⁻⁸ s and the light wavelength about 0.6 nm one can obtain *F* ≈ 5 ·10⁻³ eV/cm. For a standing laser wave the light pressure is defined by an effect of the spatial inhomogeneous field on the induced by it atomic dipole. The maximal pressure light force by the order of magnitude equals *F* ≈ *Ekd*, where *d* is an atomic dipole moment. For values of *d*≈1 D, λ≈0,6µm, *E*≈10⁶ V/cm, the force *F* ≈ 5 ·10² eve/cm. If one generates in resonator two or more standing waves with a small detuning, it will be able to control a motion direction of atoms by changing of this detuning, i.e. there is a possibility to control the jet - to turn it in the space.

For example, as an operating substance any hydrocarbon can be taken. By breaking the chemical C-H bond we form radicals that are very chemically active. The breaking of this bond one needs 4,28 eV per a bond, i.e. the radiation of 289 nm wavelength. One can use semiconductor lasers (second harmonic generation or regime of two-photon molecule excitation) to reduce a device cost. Such a radiation is intended to repel the liquid from the wall. It is possible to generate radicals needed for the nanolitograthy pattern creation at the fiber exit. The jet speed should be selected in such a way that a molecule have time to absorb a photon, but cannot react with other molecules. For the absorption time 10⁻⁹ to 10⁻⁸ sec of order in the presented configuration the jet speed equals 10 to 100 m/sec, but it should not exceed the critical velocity by which the liquid continues the laminar motion or it will be necessary to form the jet from separate spherical drops. The radiation enough to break most of C-H bonds amounts to 10⁶ - 10⁷ W/cm². The pressure generated of this radiation can amount up 5 GPa, which value does not exceed the fiber breaking strength at stretching.

During the exit of the nanojet from the nozzle the surface tension together with the radial force generated by the recoil impulses of the photons reradiated by molecules create the spatially steady jet. The time control of the jet can be performed by the duration of the laser impulse and also it is possible to generate the jet in the form of the drops. The capillary pressure of a liquid drop at the exit of the nozzle *Pₛ* = 2σ/*rₛ* will be a natural gate, where *rₛ* is a radius of the nozzle. For example, for the water by *rₛ*=7.25 nm the capillary pressure on the edge of the nozzle is *P*ₛ≈20 MPa.

The electromagnetic field generated in the near wave zone at the exit of the fiber will prevent the divergence of the nanojet. To realize the spatial space scanning of the nanojet on the substrate it is necessary to use two or four lasers with small frequency detuning. Due to a phase and an amplitude modulation it is possible to form a nonsymmetrical field deflecting the jet.

The nanojets from the chemically active substances can be used to draw a topological figure in the nanolithography. In nano- and microlithography the significant time is spended for the procedure controlling the drawing quality. In our scheme of the microscopy to reduce this time various secondary effects can be used that accompany the deposition process of the jet substance on the substrate or its etching. For example, when the jet having the speed 50 m/s hits the substrate the dynamical hit with the pressure 50 MPa takes place. It can lead to a molecules excitation with the following re-emitting in the visible and the infrared ranges.

The dynamical impact of the jet causes acoustic vibrations in the substrate, which carry the information about the structure of the surface. These acoustic phonons can be registered by an acoustic detector and one can obtain an acoustical image of the surface with a nanometer resolution.

Moreover, in the contact zone between the jet and the substrate chemical reactions take place that also can be accompanied by the radiation in the visible or the infrared ranges and remnant radicals in the jet will be reemitted in the ultraviolet range. To obtain the image from the object surface one can use wide-angle reflective ultraviolet optics. It will give a possibility to observe and to measure the image appeared on the substrate by processing the image with a computer.

Thus, one obtains a simpler analog of the scanning electron microscope, which is directly combined with the photolithography process. In this case the microscope resolution will be determined by luminescent atoms. However, due to the wide jet the image will be diffused because of a collective effect. Then the resolution of the jet microscope will be determined by a jet radius at a contact point. At the same time one can also use the wide-angle optics to observe exited atoms and molecules the in infrared and the visible ranges. Since the light sources are localized the diffraction limit is absent. Then the object is the light source itself. Thus, one can distinguish two light sources (fluorescence centers) at the distances being much less than wavelength of the source as it is shown in prototype [4]. But because of the high concentration of the luminescence centers in the liquid the source of the radiation is bright that allows to work in real time.

Naturally, the informational performance of the microscope is entirely determined by a speed of the most technological process of the nanolithography. Such an effect cannot be obtained with other methods of the scanning microscopy in real time of the technological process. The parallel methods of obtaining the image, e.g., EUV, do not allow to photograph the whole frame of the image since the resolution of electronic registration methods is limited by the number of pixels in photo matrix, that as the rule do not exceed 10⁶-10⁷, and on the typical for nanolithography photo mask can be 10¹⁰-10¹¹ pixels.

The possibility of observing the life cell without its destruction is of exceptional practical importance for the considered microscopy method. For this purpose one can use the water as a jet substance or electrolytes being a part of the cell. E.g. one can observe a penetration of bacteriophage into a cell in real time, which cell has the size about 45-140 nm. In this case the diameter of the jet and its speed can be decreased in order to increase the resolution and not to destruct the cell. Operations should be carried out not in the vacuum but directly in the liquid surrounding the cell. Thereby the jet will move at this time in the liquid. In this case the stability of the jet will be saved at small distances only. Thus, the distance between the nozzle and the cell should be about the size of the cell. Naturally, the studying the life object does not require large areas of the scanning.

### The subject matter of the invention

The scanning nanojet microscope, henceforth the microscope, comprises electrically controlled narrow band sources of the optical radiation and one ore more nozzles for generation of the scanning jet of the substance. The nozzle is the optical resonator and is made from the optically transparent capillary, the walls of which are provided for introducing of the electrically controlled narrow band optical radiation. The nozzle length is divisible by half wavelength of the optical radiation, and the wavelength value should provide the maximal symmetrical and/or nonsymmetrical radiation pressure on the substance flushed through the capillary. The external size of the nozzle is not less than wavelength of the used radiation.

The invention is characterized in that the substance flushed through the capillary can be in a gaseous, a liquid, a radical, a plasma one or its combination. The inner profile of the nozzle capillary has a specified form.

In the simplest case the optically transparent capillary has an inner diameter no less than 1 nm.

The capillary is convergent to the nozzle and is coated by a light reflecting coating except the inner part of the nozzle capillary that is an optical resonator. An interaction between the optical radiation and the substance takes place within the nozzle (resonator).

To observe objects the microscope provides for a possibility of the relative displacement of least one nozzle and the substrate.

The invention comprise at least one additional wide-angle optical system with a detector for collecting of the optical radiation within the range from infrared to ultraviolet arisen from a contact zone between the jet and an object and for a posterior conversion of this optical radiation into an electrical signal that is processed by a computer to obtain an image of the object.

According to one embodiment of the invention at least one jet and two optical systems with the detectors for collecting of the optical radiation within the range from infrared to ultraviolet arisen from the contact zone between the jet and the object with the posterior conversion of this optical radiation into the electrical signal for the computer processing are used for obtaining of a stereoscopic image of the object

According to other embodiment at least two jets and one or more optical systems with the detectors for collecting of the optical radiation within the range from infrared to ultraviolet arisen from the contact zone between the jet and the object with the posterior conversion of this optical radiation into the electrical signal for the computer processing are used for obtaining of a multidimensional image of the object.

One more embodiment of the invention is an acoustic detector joined with object to collect the acoustic radiation arisen by the contact between the jet and the object with the posterior conversion of this acoustic detector into the electrical signal for the computer processing used for obtaining of an acoustic image of the object.

The method of operating the microscope lies in the control of the jet which is realized by a generation of the non-homogenous light pressure on the jet in the capillary of the nozzle which results in the specified deflection of the jet from the central axis at the capillary exit of the nozzle and/or in an interruption of the light pressure through time. To interrupt the radiation pressure in time one can set length of the jet and one can make it consisted from drops that increases the stability of the jet near critical speeds.

Another embodiment of the method of operating the microscope is that that a spatial breaking of a jet is realized by switching off of the optical radiation.

In order to prevent the capillary from blocking by cluster formations of the liquid (bubstones) the pressure of the liquid introducing into the capillary is chosen to be greater than the pressure of a bubstone formation for the liquid. However, it has to be lower than the capillary pressure at the exit of the nozzle for interruption of the jet motion when the optical radiation is switched off.

The invention is presented on figures more detailed
Fig.1. a scheme of a scanning nanojet microscope.
Fig.2. a structure of a capillary nozzle.

### Brief description of the drawings

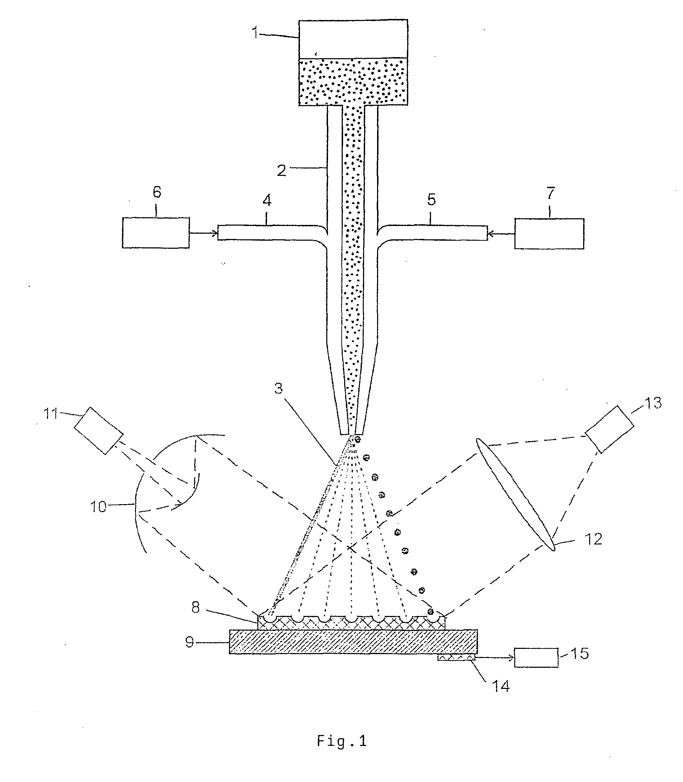

On Fig.1 the scheme of a scanning nanojet microscope is presented. Here, 1 - a reservoir with a liquid under the pressure. The liquid comes through a convergent fiber 2 to a nozzle that forms a nanoscaled jet 3. At the same time two optical signals formed by an electrically controlled narrow-band source 6, 7 of the radiation are supplied to the nozzle by waveguides 4,5. By an electrical modulation of optical signals from the sources 6,7 the spatially non-homogenous electromagnetic field is formed at the end of nozzle, which field realizes a precise spatial scanning of the jet 3 in the xy plane along a substrate. The substrate is placed on a mechanically movable table 9 that realizes a less accurate displacement in the plane xy. The jet 3 realizes the etching and/or the drawing of a lithographic figure on an explored sample 8. The image formation is realized in different spectral ranges from the sound range to the ultraviolet one. The signal arises in a contact zone between the sample 8 and the jet as a result of a mechanical impact and a generation of the radiation to physical and chemical effects. The signal within the range from infrared to ultraviolet is detected by reflective optics 10 and a detector 11 corresponding to this range or within the optical range by a wide-angle optical system 12 (a system of lens) and a corresponding detector 13. To collect an acoustic signal one uses an acoustic converter 14 acoustically joined with the substrate, a signal of which is come in an acoustic detector 15. The information from detectors is processed by a computer and displayed on a monitor.

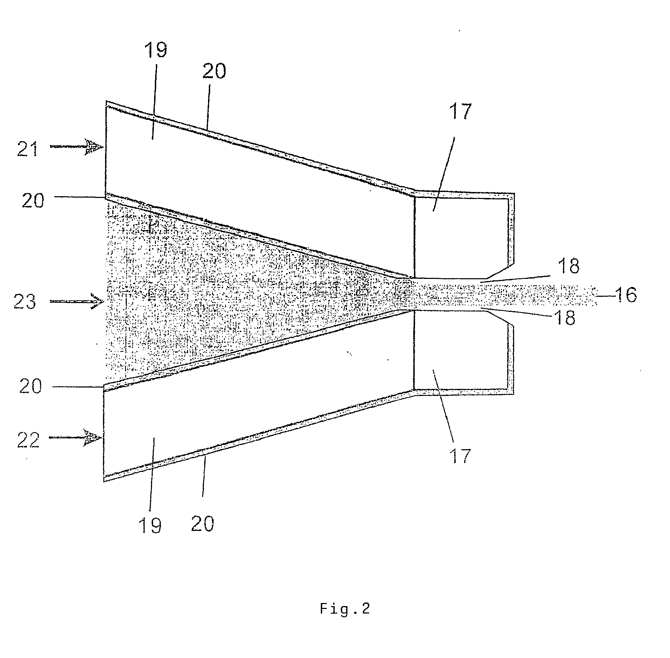

On Fig.2 the structure of the capillary nozzle is presented. Here, the formation of the jet 16 in a zone of the capillary nozzle 17 is shown. The nozzle 17 is an optical resonator, which length is divisible by half wavelength of the optical radiation introduced in the nozzle walls. The optical radiation generates the uniform radiation pressure on the jet 16 that moves the substance of the jet away from the walls of the nozzle 17 and forms a gap 18 insulating from the walls. A convergent optically transparent capillary 19 is coated by a metallic reflecting coating that at the same time carries out the chemical protection of the capillary. A modulated optical radiation 21, 22 and an active substance 23 under the pressure are introduced into the capillary.

### Examples of invention embodiments.

Let's consider possibilities of the technical realization of the scanning nanojet microscope.

To generate a nanocapillary one can use hollow optical wave guides elongated in the locally heated state to a necessary inner radius. Here, worked-out technologies of the near field probes production can be applied.

The concentration of the light beam is realized in the convergent optical fiber, the walls of which should be coated by the reflecting material (e.g. by a metal) to reduce the losses.

For the collection of the optical information one can use wide-angle serial objectives and photodiodes.

For the collection of the ultraviolet radiation one can use the wide-angle reflective optics, e.g. the optics for the ultraviolet lithography, and corresponding photo detectors.

The control of the scanning process and of the breaking the jet is realized by a system of semiconductor lasers or light diodes controlled electrically.

The obtaining of the acoustical image can be realized by piezoelectric detectors placed on the substrate or at the nozzle.

The microscope by its use in the nanolithography is to operate in real time of the technological process and to realize the monitoring of each pixel of the pattern forming on the substrate. When the irremovable defect is detected, it has to generate a signal about a defect of the whole chip and about a stopping of the further drawing. That will save the time of the whole technological cycle.

Let us calculate the time needed to obtain one image frame of the scanning nanojet microscopy with a specified resolution of the nanojet nanolithograph. Here the procedure of the pattern formation and its registration are combined. E.g. as a working liquid let us consider the hydrocarbon. Let us set the jet speed to be 50 m/s, its diameter - 14,5 nm, distances between elements of the topological figure equals 7,25 nm. The topological figure is presented in the form of lines having in length 1 cm and in width 14,5 nm and the distance between the lines of 7,25 nm. Then the maximum density of the pixels of 14,5 nm in size is 3.17·10¹¹ per cm². The maximum modulation frequency of the nanolihograph jet in the time is 3.45·10⁹ Hz, the maximum frequency of the lines in the frame 4,6·10⁵ Hz. By such speeds of the scan the information has to be saved in the buffer high-performance memory for its subsequent processing in computer.

In the present time there are processors with a gigahertz performance. It is enough for the writing of the information from the microscope in real time of the technological process. A person cannot process obtained giga- and terabyte volumes of the information. The monitoring procedure has to be realized by a computer. The operator can realize a sampling test of single frames with a resolution no more then 10⁶ pixels per 1 frame only.

At the present time the offered microscope is technologically realizable. It does not contain expensive units such as a synchrotron, high-quality ultraviolet reflective optics, magnetic and optical lenses.

Due to use of the liquid jet with the high density of the substance the offered microscope is much more efficient in the speed than the scanning ion or electron microscopes with the same resolution. At the same time due to the electrical neutrality of the jet all problems of the investigation of dielectric surfaces peculiar to the ion or electron microscopes are eliminated.

In the most of practical applications the offered microscope can substitute scanning tunnel microscopes, atomic force microscopes, near-field microscopes, etc, since it has the greater field of view comparable with the scanning electron microscopes only.

### Advantages of the offered microscope:

- A storage of the image in the computer memory in giga- and terabyte volumes.
- A possibility of the generation of video films with a transformation of the time scale
- A considerable reducing of the device prime cost in comparison with the scanning electron and ion microscopes and with the X-ray and the ultraviolet microscopes.
- An increase of the field of view and the obtaining speed of the image in comparison with the mechanically scanning microscopes.
- A possibility to obtain the analytic information about the object in the different energy regions from infrared to ultraviolet that allows realizing an additional chemical analysis.
- A possibility to use several nanojets subsequently or parallel in order to control the image and to form the stereoscopic and multidimensional images.
- A possibility to study dielectric and biological objects without they destruction and without they coating by conductive materials.
- A possibility to investigate the life cell and other biological objects.

### Literature

1. Encyclopedia of physics. Moscow (Sovetskaya enciklopedia) 1988-1998. Vol. 3, pp.144-150; Vol. 4, pp.537-539, Vol. 5, pp. 574-578, 581 (in Russian).
2. R.P. Seisyan, "Extreme ultraviolet nanolithography for ULSI: A review," Technical Physics. 75, pp. 535-545, 2005.
3. Volker Westphal, Jens Seeger, Tim Salditt and Stefan W Hell. Stimulated emission depletion microscopy on lithographic nanostructures. http://stacks.iop.org/0953-4075/38/S695 , Print publication: Issue 9 (14 May 2005).
4. Dyba M, Jakobs S, Hell SW, Immunofluorescence stimulated emission depletion microscopy. Nat Biotechnol. 2003 Nov;21(11):1303-4
5. Timoshchenko I.A., Ilyanok A.M. Formation of nanojet of radicals for nanolithography purposes. International Congress of Nanotechnology. November 1-3, 2005. San Francisco.
6. Moseler M. and Landman U., Formation, Stability, and Breakup of Nanojets, Science 2000 289: 1165-1169.
7. Eggers J., Dynamics of liquid nanojets, Phys. Rev. Lett. 89, 084502 (2002) 8. 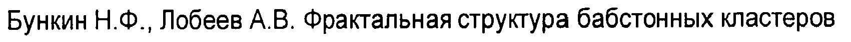 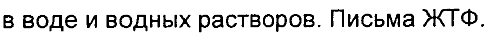 1993, 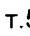 58, 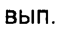 1, 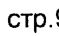 91
9. Mechanika razrushenia zhidkosti. Proc. Institute of Hydrodynamics. Novosibirsk, 1992. Vol. 104, pp.19, 22, 26, (1992) (In Russian).
10. Bologa M.K. Rabotaet pustota. Chisinau 1985, pp. 18.
11. I.A. Timoshchenko. Design of vectorial light beam in free space, in Proc. of IV International conference of young scientists Optics-05, p. 398 (October 17-21, 2005, St.-Petersburg, Russia)
12. Encyclopedia of physics. Moscow (Sovetskaya enciklopedia) 1988-1998. Vol. 1 pp. 553-554.
13. Deladi S, Berenschot J W, Tas N R, at al. Fabrication of micromachined fountain pen with in situ characterization possibility of nanoscale surface modification. J. Micromech. Microeng. 15 (2005) 528-534.

## Claims

1. A scanning nanojet microscope comprising electrically controlled narrow band sources of an optical radiation and one or more nozzles for generation of a scanning jet of a substance **characterized in that** the nozzle is an optical resonator and is made from an optically transparent capillary, walls of which are provided for introducing of the electrically controlled narrow band optical radiation and nozzle length is divisible by half wavelength of the optical radiation, wherein wavelength of the optical radiation is chosen to provide the maximal symmetrical and/or nonsymmetrical light pressure on the substance flushed through the capillary, and the external size of the nozzle is not less than wavelength of the used optical radiation.

2. The microscope according to claim 1, **characterized in that** the substance flushed through the capillary can be in a gaseous, a liquid, a radical, a plasma one or its combination.

3. The microscope according to claim 1, **characterized in that** the inner profile of the nozzle capillary has a specified form.

4. The microscope according to any claims 1-3, **characterized in that** the optically transparent capillary has an inner diameter no less than 1 nm.

5. The microscope according to any claims 1-4 **characterized in that** the optically transparent capillary is convergent to the nozzle and is coated by a light reflecting coating except the inner part of the capillary of the nozzle.

6. The microscope according to any claims 1-5, **characterized in that** the device is realized with a possibility of the relative displacement of at least one nozzle and the substrate.

7. The microscope according to any claims 1-6, **characterized by** at least one additional wide-angle optical system with a detector for collecting of the optical radiation within the range from infrared to ultraviolet arisen in a contact zone between the jet and an object and for a posterior conversion of this optical radiation into an electrical signal that is processed by a computer to obtain an image of the object.

8. The microscope according to any claims 1-7, **characterized in that** at least one jet and two optical systems with the detectors for collecting of the optical radiation within the range from infrared to ultraviolet arisen in the contact zone between the jet and the object with the posterior conversion of this optical radiation into the electrical signal for the computer processing are used for obtaining of a stereoscopic image of the object.

9. The microscope according to any claims 1-7, **characterized in that** at least two jets and one or more optical systems with the detectors for collecting of the optical radiation within the range from infrared to ultraviolet arisen from the contact zone between the jet and the object with the posterior conversion of this optical radiation into the electrical signal for the computer processing are used for obtaining of a multidimensional image of the object.

10. The microscope according to any claims 1-7, **characterized in that** an acoustic detector joined with the object to collect the acoustic radiation arisen by the contact between the jet and the object with the posterior conversion of this acoustic detector into the electrical signal for the computer processing is used for obtaining of an acoustic image of the object.

11. The method of operating the scanning nanojet microscope according to any claims 1-10, **characterized in that** the control of the jet is realized by a generation of the non-homogenous light pressure on the jet in the capillary of the nozzle which results in the specified deflection of the jet from the central axis at the capillary exit of the nozzle and/or in an interruption of the light pressure through time.

12. The method of operating the microscope according to claim 11, **characterized in that** the non-homogenous light pressure on the jet in the capillary is generated due to a spatial phase or an amplitude shift of the optical radiation from at least one electrically controlled narrow band source.

13. The method of operating the microscope according to any claims 11, 12, **characterized in that** a spatial breaking of the jet is realized by switching off of the optical radiation.

14. The method of operating the device according to any claims 11-13, **characterized in that** the pressure of the liquid introducing into the capillary is chosen to be greater than the pressure of a bubstone formation for the liquid, but lower than the capillary pressure at the exit of the nozzle.
